# EUROPEAN PATENT SPECIFICATION

(11) **EP 4 080 319 B1**
(45) Date of publication and mention of the grant of the patent: **26.11.2025**
(21) Application number: 20914006.0
(22) Date of filing: 16.01.2020
(51) Int. Cl.: G06F 1/06, H03K 3/017

(54) **CLOCK SIGNAL GENERATOR, ON-CHIP CLOCK SYSTEM, AND CHIP**
TAKTSIGNALGENERATOR, ON-CHIP-TAKTSYSTEM UND CHIP
GÉNÉRATEUR DE SIGNAUX D'HORLOGE, SYSTÈME D'HORLOGE SUR PUCE ET PUCE

(43) Date of publication of application: 26.10.2022
(73) Proprietor: Huawei Technologies Co., Ltd., Shenzhen, Guangdong 518129, (CN)
(72) Inventor: SONG, Jun, Shenzhen, Guangdong 518129 (CN); JIA, Ligang, Shenzhen, Guangdong 518129 (CN)
(74) Representative: Goddar, Heinz J.
(86) International application number: PCT/CN2020/072413
(87) International publication number: WO 2021/142697

(56) References cited:
- CN-A- 1 773 855
- CN-A- 105 553 445
- CN-A- 107 222 170
- CN-B- 103 546 121
- CN-U- 206 099 920
- CN-U- 207 720 101
- CN-U- 209 845 366
- US-A1- 2014 368 284
- US-A1- 2019 097 616
- US-B1- 8 232 846

## Description

### TECHNICAL FIELD

Embodiments of this application relate to the electronic circuit technologies, and in particular, to a clock signal generator, an on-chip clock system, and a chip.

### BACKGROUND

With development of electronic technologies such as an artificial intelligence technology, a communications technology, and a semiconductor technology, functions of an on-chip system become increasingly complex. To ensure high reliability and a high running rate of the on-chip system, a clock signal generator generally needs to be disposed inside the on-chip system, so as to provide an accurate and stable clock signal for the on-chip system.

In a related technology, a flip-flop and a comparator are usually disposed in a clock signal generator. A signal that is output by an output end of the comparator is provided to an input end of the flip-flop, so that the flip-flop generates a clock pulse at an output end based on the signal received by the input end. Generally, there is a delay between the input end and the output end of the comparator, and the delay usually changes based on a static operating point, a temperature drift, and the like of a circuit. As a result, a clock frequency output by a clock output circuit changes, and stability of a frequency of a clock signal output by the clock signal generator is reduced. Therefore, how to enable the clock signal generator to output a clock signal with a stable frequency becomes a problem.

US 2014/368284 A1 discloses a relaxation oscillator. The relaxation oscillator includes a R-S latch, a first delay circuit and a second delay circuit. The input terminal of the first delay circuit is coupled to the Q output terminal of the R-S latch, and the output terminal of the first delay circuit is coupled to the reset terminal of the R-S latch. The input terminal of the second delay circuit is coupled to the inversion Q output terminal of the R-S latch, and the output terminal of the second delay circuit is coupled to the set terminal of the R-S latch. When the input terminal of the first delay circuit inputs a first logic voltage, after a delay time, the output terminal of the first delay circuit outputs a second logic pulse. When the input terminal of the second delay circuit inputs the first logic voltage, after the delay time, the output terminal of the second delay circuit outputs the second logic pulse.

CN 103546121 A discloses an RC oscillator with lower noise and low power consumption. The RC oscillator comprises a comparer, a two-phase non-overlapped clock generating circuit, a first charging circuit, a second charging circuit, a switch selection circuit and a reference voltage generating circuit. The first charging circuit comprises a first resistor, a first capacitor, a first switch and a fifth switch. The second charging circuit comprises a second resistor, a second capacitor, a fourth switch and a sixth switch. The comparer comprises the positive input end, the negative input end and the output end. The low-power-consumption RC oscillator provided by the embodiment uses the resistors to substitute a current source to charge the capacitors, so that noise of devices is reduced.

US 8,232,846 B1 discloses an RC oscillator. The oscillator includes a current generator circuit configured to generate a current. A capacitor is configured to be charged by the current. An inverter includes an input coupled to the capacitor. An output of the inverter goes high when a voltage across the capacitor reaches a threshold voltage of the inverter. A switch coupled to the output of the inverter and the capacitor is configured to close when the output of the inverter goes high. This discharges the capacitor. The output of the inverter goes low when the capacitor is discharged and the switch is opened. Clock generator logic is configured to receive the output of the inverter and generate a clock signal. The current is proportional to the threshold voltage of the inverter.

CN 107222170 A discloses an oscillator circuit, and belongs to the technical field of semiconductor integrated circuits. The circuit comprises a first phase inverter, a second phase inverter, a third phase inverter, an RS trigger and a capacitor, wherein the input of the first phase inverter is connected with the output of an oscillator; the output of the first phase inverter is connected with one end of the capacitor and the inputs of the second phase inverter and the third phase inverter; the other end of the capacitor is grounded; the output of the second phase inverter is connected with a reset end R of the RS trigger; the output of the third phase inverter is connected with a set end of the RS trigger; and an output end of the RS trigger is connected with the output of the oscillator. Based on the difference between turning points of the second phase inverter and the third phase inverter, a voltage on the capacitor changes linearly between the two turning points, so that a stable frequency is constructed. Compared with a conventional oscillator, the oscillator has the advantage that the frequency of the oscillator is mainly controlled by the turning points of the second phase inverter and the third phase inverter, so that high stability is achieved.

### SUMMARY

According to a clock signal generator, an on-chip clock system, and a chip provided in this application, input ends of a flip-flop are respectively coupled to a first electrode of a first transistor and a first electrode of a second transistor, so that an output frequency of the clock signal generator is related only to turn-on/off times of the first transistor and the second transistor. In this way, the clock signal generator can generate a clock signal with a stable frequency.

The following technical solutions are used in this application.

According to a first aspect, an embodiment of this application provides a clock signal generator. The clock signal generator includes a first transistor, a second transistor, a flip-flop, a power supply end, and a control signal generation circuit. A first electrode of the first transistor and a first electrode of the second transistor are directly coupled to the power supply end, and a second electrode of the first transistor and a second electrode of the second transistor are directly coupled to a common ground. A first input end of the flip-flop is coupled to the first electrode of the first transistor, and a second input end of the flip-flop is coupled to the first electrode of the second transistor. Signal output ends of the control signal generation circuit are respectively coupled to a control electrode of the first transistor and a control electrode of the second transistor. The control signal generation circuit periodically provides a control signal to the control electrode of the first transistor and the control electrode of the second transistor, so that the first transistor and the second transistor are alternately turned on and turned off based on the control signal. A first output end of the flip-flop is configured to output a clock signal.

The first input end and the second input end of the flip-flop are respectively coupled to the first electrode of the first transistor and the first electrode of the second transistor, so that a high-level signal or a low-level signal received by the first input end and the second input end of the flip-flop is related only to turn-on times or turn-off times of the first transistor and the second transistor, and a period or a frequency of a clock pulse signal at an output end of the flip-flop is related only to the turn-on times and the turn-off times of the first transistor and the second transistor. In this way, a clock frequency change caused by a change of a delay of a signal received by the flip-flop with a temperature can be avoided, so that a frequency of a clock signal output by the clock signal generator can be more stable.

In a possible implementation, the control signal output by the output end of the control signal generation circuit is a voltage signal. In this case, the control signal generation circuit may include two output ends, where one output end is coupled to the control electrode of the first transistor, and the other output end is coupled to the control electrode of the second transistor. The control signal generation circuit may apply a generated voltage signal between the control electrode and the first electrode of the first transistor and between the control electrode and the second electrode of the second transistor, so as to alternately control turn-on and turn-off of the first transistor and the second transistor.

In a possible implementation, the clock signal generator further includes a first capacitor and a second capacitor. A first electrode of the first capacitor is coupled to the control electrode of the first transistor. A second electrode of the first capacitor is coupled to the common ground. The first transistor is periodically turned on or turned off based on charging/discharging of the first capacitor. A first electrode of the second capacitor is coupled to the control electrode of the second transistor. A second electrode of the second capacitor is coupled to the common ground. The second transistor is periodically turned on or turned off based on charging/discharging of the second capacitor.

The first transistor and the second transistor are controlled through charging/discharging of the first capacitor and the second capacitor, so as to trigger level flipping of a first output end and a second output end of the flip-flop to generate a clock signal. A charging/discharging time of a capacitor is related to a material, a capacity, and a charging/discharging constant of the capacitor. Therefore, a clock frequency output by the clock signal generator can be controlled by controlling charging/discharging times of the first capacitor and the second capacitor. This avoids a change of a frequency of an output clock signal caused by a temperature drift or a change of a static operating point of another component such as an integrated operational amplifier in the clock signal generator, so that the frequency of the clock signal output by the clock signal generator can be more stable. In addition, in some application scenarios, when a relatively high clock frequency is required, a capacitor with a small capacity and a short charging/discharging time may be used. When a relatively low clock frequency is required, a capacitor with a large capacity and a long charging/discharging time may be used. In this way, a maximum frequency of a clock signal to be output by the clock signal generator can be effectively increased. This further improves performance of the clock signal generator. The control signal output by the output end of the control signal generation circuit is a current signal. The control signal generation circuit alternately and periodically provides the current signal to the first electrode of the first capacitor and the first electrode of the second capacitor to charge the first capacitor and the second capacitor.

In a possible implementation, the clock signal generator further includes a third transistor. A control electrode and a first electrode of the third transistor are coupled to the power supply end, and a second electrode of the third transistor is coupled to the common ground. The control signal generation circuit generates a current signal based on a voltage signal between the first electrode and the second electrode of the third transistor.

In a possible implementation, the clock signal generator further includes a current mirror circuit. The control signal generation circuit converts a voltage between the first electrode and the second electrode of the third transistor into a current, and provides the current to the current mirror circuit. The current mirror circuit performs mirror processing on the received current based on a preset proportion, and provides a processed current to the first electrode of the first capacitor and the first electrode of the second capacitor.

A requirement on the control signal generation circuit can be reduced by disposing the current mirror circuit. When a relatively large current needs to be input to the clock signal generator, the current mirror circuit may be used for implementation, so that stability of the control signal generation circuit can be improved. This further improves stability of the clock signal generated by the clock signal generator.

In a possible implementation, the clock signal generator further includes a first selector and a second selector. A control end of the first selector is coupled to the first output end of the flip-flop. A first input end of the first selector is coupled to the output end of the control signal generation circuit. A second input end of the first selector is coupled to the common ground. An output end of the first selector is coupled to the control electrode of the first transistor. A control end of the second selector is coupled to the second output end of the flip-flop. A first input end of the second selector is coupled to the output end of the control signal generation circuit. A second input end of the second selector is coupled to the common ground. An output end of the second selector is coupled to the control electrode of the second transistor. The first selector periodically gates the first input end and the second input end of the first selector under control of a clock signal that is output by the first output end of the flip-flop, so that the first capacitor is periodically charged/discharged. The second selector periodically gates the first input end and the second input end of the second selector under control of the clock signal that is output by the first output end of the flip-flop, so that the second capacitor is periodically charged/discharged.

In a possible implementation, the first input end of the flip-flop is coupled to the first electrode of the second transistor through an even quantity of phase inverters.

In a possible implementation, the second input end of the flip-flop is coupled to the first electrode of the third transistor through an even quantity of phase inverters.

A driving capability of a circuit can be improved by disposing the phase inverter. This increases flipping speeds of level signals at the first input end and the second input end of the flip-flop.

In a possible implementation, a quantity of first transistors, a quantity of second transistors, and a quantity of third transistors are in proportion. For example, the quantity of first transistors, the quantity of second transistors, and the quantity of third transistors are 1:1:1. A parameter of the first transistor, a parameter of the second transistor, and a parameter of the third transistor are the same. Specifically, the first transistor, the second transistor, and the third transistor may have a same physical parameter and a same operating parameter, that is, have same parameters such as a conduction voltage drop, an internal resistance, and a power. In this way, the temperature drift of the static operating point of the clock signal generator is reduced, so that the static operating point of the clock signal generator is more stable.

According to a second aspect, an embodiment of this application provides an on-chip clock system. The on-chip clock system includes the clock signal generator according to the first aspect.

According to a third aspect, an embodiment of this application provides a chip. The chip includes the on-chip clock system according to the second aspect.

### BRIEF DESCRIPTION OF DRAWINGS

To describe the technical solutions in embodiments of this application more clearly, the following briefly introduces the accompanying drawings for describing embodiments of this application. It is clear that the accompanying drawings in the following description show merely a part of embodiments of this application, and a person of ordinary skill in the art may still derive other drawings from these accompanying drawings without creative efforts.
FIG. 1 is a schematic diagram of a structure of a clock circuit in the conventional technology;
FIG. 2 is a schematic diagram of a structure of a clock signal generator according to an embodiment of this application;
FIG. 3 is a schematic diagram of another structure of a clock signal generator according to an embodiment of this application;
FIG. 4 is a schematic diagram of still another structure of a clock signal generator according to an embodiment of this application;
FIG. 5 is a schematic diagram of a structure of a voltage-current conversion circuit according to an embodiment of this application;
FIG. 6 is a schematic diagram of still another structure of a clock signal generator according to an embodiment of this application; and
FIG. 7 is a schematic diagram of a specific structure of a clock signal generator according to an embodiment of this application.

### DESCRIPTION OF EMBODIMENTS

The following clearly and completely describes the technical solutions in embodiments of this application with reference to the accompanying drawings in embodiments of this application. It is clear that the described embodiments are a part but not all of embodiments of this application. All other embodiments obtained by a person of ordinary skill in the art based on embodiments of this application without creative efforts shall fall within the protection scope of this application.

The term "first", "second", or the like mentioned in this specification does not indicate any order, quantity, or importance, but is used only for distinguishing between different components. Likewise, the term "a/an", "one", or the like is not intended to indicate a quantity limitation either, but is intended to indicate at least one. The term "coupling", "connection", "link", or the like is not limited to a physical or mechanical connection, but may include an electrical connection, whether directly or indirectly.

The term "unit" mentioned in this specification is usually a functional structure that is obtained through division based on logic, and the "unit" may be implemented only by hardware, or implemented by a combination of software and hardware.

In embodiments of this application, the term "and/or" describes an association relationship between associated objects and indicates that three relationships may exist. For example, A and/or B may indicate the following three cases: Only A exists, both A and B exist, and only B exists.

In embodiments of this application, the word "example", "for example", or the like is used to represent giving an example, an illustration, or a description. Any embodiment or design scheme described as "example" or "for example" in embodiments of this application should not be explained as being more or having more advantages than another embodiment or design scheme. Exactly, use of the word "example", "for example", or the like is intended to present a related concept in a specific manner.

In the descriptions of embodiments of this application, unless otherwise stated, "a plurality of" means two or more than two. For example, a plurality of processing units refer to two or more processing units. A plurality of systems refer to two or more systems.

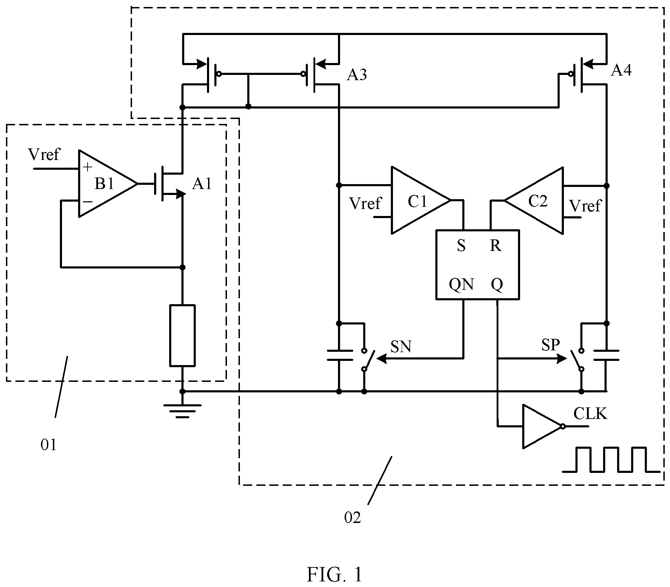

FIG. 1 shows a typical clock circuit in the conventional technology. As shown in FIG. 1, the clock circuit includes a voltage-current conversion unit 01 configured to convert a voltage signal into a current signal, and a clock signal unit 02 configured to generate a clock signal. The voltage-current conversion unit 01 is a previous-stage circuit of the clock circuit. An integrated operational amplifier B1 converts a voltage into a current and provides the current to a gate electrode of a transistor A1, so that a signal is input to the clock signal unit 02 through the transistor A1. The clock signal unit 02 is a post-stage circuit of the clock circuit. Two comparators C1 and C2 are disposed in the clock signal unit 02, and are configured to generate trigger signals of an SR flip-flop. It can be learned from FIG. 1 that, one of signal input ends of the comparator C1 and one of signal input ends of the comparator C2 are respectively connected to a drain electrode of a transistor A3 and a drain electrode of a transistor A4. A gate electrode of the transistor A3 and a gate electrode of the transistor A4 are controlled by a drain current of the transistor A1, so that a signal used to trigger the SR flip-flop depends on signals output by the voltage-current conversion circuit 01, the comparator C1, and the comparator C2. In this way, a clock signal CLK generated by the SR flip-flop has a feature of following the current generated by the integrated operational amplifier B1 and the signals output by the comparator C1 and the comparator C2. When a signal VREF that is input to an input end of the integrated operational amplifier B1 or a component in the voltage-current conversion unit 01 changes with a change of a temperature or a power supply, the clock signal CLK also changes. In this case, stability of the clock signal output by the clock circuit is greatly reduced. In addition, compared with input signals of the comparator C1 and the comparator C2, output signals of the comparator C1 and the comparator C2 usually have a delay. The delay usually limits a maximum frequency of the clock signal output by the clock circuit. In view of this, an embodiment of this application provides a clock signal generator, so that a comparator may not be disposed, and a clock signal is generated by controlling a first transistor and a second transistor to be turned on or turned off. A frequency of the clock signal is related only to turn-on and turn-off times of the first transistor and the second transistor. The clock signal with a stable frequency can be output by stably controlling the turn-on and turn-off times of the first transistor and the second transistor. In addition, in some implementations provided in this embodiment of this application, turn-on and turn-off of the first transistor and the second transistor are controlled through charging/discharging of a capacitor, so that the turn-on and turn-off times of the first transistor and the second transistor are not affected by a delay, a temperature drift, and the like of an integrated operational amplifier in a voltage-current conversion unit. This can further improve a maximum frequency of the clock signal output by the clock circuit.

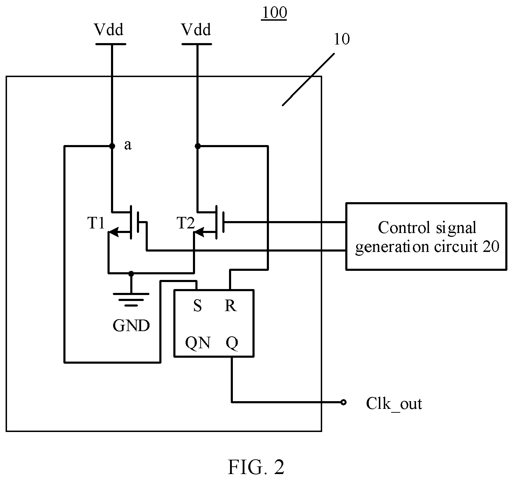

FIG. 2 is a schematic diagram of a structure of a clock signal generator according to an embodiment of this application.

In FIG. 2, a clock signal generator 100 includes a power supply end Vdd and a clock signal generation circuit 10. The clock signal generation circuit 10 includes a transistor T1, a transistor T2, and an SR flip-flop.

In this embodiment, the transistor T1 and the transistor T2 each include a control electrode, a first electrode, and a second electrode. The first electrode of the transistor T1 and the first electrode of the transistor T2 are separately coupled to the power supply end Vdd. The power supply end Vdd is configured to receive electric energy provided externally. The second electrode of the transistor T1 and the second electrode of the transistor T2 are separately coupled to a common ground Gnd. The transistor T1 and the transistor T2 herein may be insulated gate field effect transistors, for example, may be PMOS transistors or NMOS transistors. This is not limited herein. When the transistor T1 and the transistor T2 are NMOS transistors, the control electrode may be a gate electrode, the first electrode may be a drain electrode, and the second electrode may be a source electrode. When the transistor T1 and the transistor T2 are PMOS transistors, the control electrode may be a gate electrode, the first electrode may be a source electrode, and the second electrode may be a drain electrode. The figure schematically shows a case in which the transistor T1 and the transistor T2 are NMOS transistors.

The SR flip-flop includes an input end S, an input end R, an output end QN, and an output end Q. The input end S of the SR flip-flop is connected to the first electrode of the transistor T1. The input end R of the SR flip-flop is connected to the first electrode of the transistor T2. The output end QN or the output end Q of the SR flip-flop is configured to output a clock signal. FIG. 2 schematically shows a case in which the output end Q of the SR flip-flop outputs a clock signal. That is, the clock signal generator 100 outputs the clock signal through an external interface Clk_out. In a working process of the SR flip-flop, when level signals or logic signals currently received by the input end S and the input end R of the SR flip-flop are different from a level signal or a logic signal received last time, jumps of a level signal at the output end QN and a level signal at the output end Q of the SR flip-flop are triggered. To make a signal output by the clock signal generator 100 more stable, generally, the input end S and the input end R of the SR flip-flop receive signals of different levels or different logic at a same moment. That is, when the input end S receives "logic 0", the input end R receives "logic 1"; when the input end S receives "logic 1", the input end R receives "logic 0".

As shown in FIG. 2, the clock signal generator 100 may further include a control signal generation circuit 20 configured to control turn-on and turn-off of the transistor T1 and the transistor T2. The control signal generation circuit 20 may include but is not limited to a programmable logic controller (PLC, Programmable Logic Controller), a digital signal processor (DSP, digital signal processor), a signal generator, and the like. Output ends of the control signal generation circuit 20 are respectively coupled to the control electrode of the transistor T1 and the control electrode of the transistor T2.

Specifically, as shown in FIG. 2, the control signal generation circuit 20 may include two output ends, where one output end is coupled to the control electrode of the transistor T1, and the other output end is coupled to the control electrode of the transistor T2. Herein, a signal output by the control signal generation circuit 20 may be a voltage signal. The transistor T1 is used as an example. The control signal generation circuit 20 and the second electrode of the transistor T1 may be coupled to the same common ground, so that the control signal generation circuit 20 may apply a voltage signal between the control electrode and the second electrode of the transistor T1. When the voltage signal is greater than a turn-on voltage of the transistor T1, the transistor T1 is turned on. When the voltage signal is stopped being applied, the transistor T1 is turned off. In this embodiment, the control signal generation circuit 20 may control the transistor T1 and the transistor T2 to be alternately turned on and turned off. That is, when the transistor T1 is turned on, the transistor T2 is turned off; when the transistor T2 is turned on, the transistor T2 is turned off. Therefore, the input end S and the input end R of the SR flip-flop can alternately receive signals of different levels.

With reference to the circuit structure shown in FIG. 2, a working principle of the clock signal generator 100 in this embodiment of this application is described.

A working status of the transistor T1 is used as an example. A signal received by the input end S of the SR flip-flop is first described. When the transistor T1 is turned on, an electric potential at a node a is an internal resistance voltage drop of the transistor T1. Generally, the internal resistance voltage drop of the transistor T1 is very small and can be almost ignored. Herein, the electric potential at the node a may be considered as 0 V In this case, the input end S of the SR flip-flop receives a low-level signal or "logic 0". When the transistor T1 is turned off, the electric potential at the node a is an electric potential of the power supply end Vdd. In this case, the input end S of the SR flip-flop receives a high-level signal or "logic 1". For a working status of the transistor T2 and a signal received by the input end R of the SR flip-flop, refer to descriptions of the transistor T1 and the signals received by the input end S of the SR flip-flop. Details are not described herein again.

In a first time period, the transistor T1 is controlled to be turned on, and the transistor T2 is controlled to be turned off. In this case, the input end S of the SR flip-flop receives a low-level signal or "logic 0", and the input end R of the SR flip-flop receives a high-level signal or "logic 1". In this case, the Q end outputs the low-level signal or the "logic 0". In a second time period, the transistor T1 is controlled to be turned off, and the transistor T2 is controlled to be turned on. In this case, the input end S of the SR flip-flop receives a high-level signal or "logic 1", and the input end R of the SR flip-flop receives a low-level signal or "logic 0". In this case, the Q end outputs the high-level signal or the "logic 1". Therefore, based on a to-be-generated clock cycle, the transistor T1 and the transistor T2 are periodically controlled to be turned on or turned off, so that high-level and low-level signals, that is, clock pulse signals, can be alternatively output at the output end Q of the SR flip-flop.

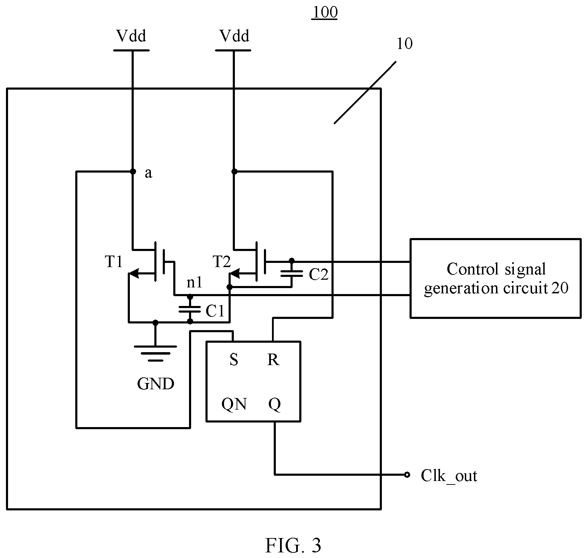

It can be learned from FIG. 2 that, in this embodiment of this application, the input end S and the input end R of the SR flip-flop are respectively connected to the first electrode of the transistor T1 and the first electrode of the transistor T2, so that signals that are input to the input end S and the input end R of the SR flip-flop can be separated from control signals that control the transistor T1 and the transistor T2 to be turned on or turned off. In comparison with the clock circuit shown in FIG. 1 in which the output end of the comparator is connected to the input end of the SR flip-flop, in this embodiment of this application, a period or a frequency of the clock pulse signal of the output end of the SR flip-flop is related only to turn-on times and turn-off times of the transistor T1 and the transistor T2. The SR flip-flop can output a stable clock signal provided that the turn-on times and the turn-off times of the transistor T1 and the transistor T2 are stably controlled. This avoids a clock frequency change caused by a change of a delay of a signal output by the comparator with a temperature, so that the frequency of the clock signal output by the clock signal generator 100 is more stable. Signals applied to the control electrode of the first transistor T1 and the control electrode of the second transistor T2 may alternatively be implemented through charging/discharging of a capacitor. Specifically, FIG. 3 is a schematic diagram of a structure of another clock signal generator according to an embodiment of this application.

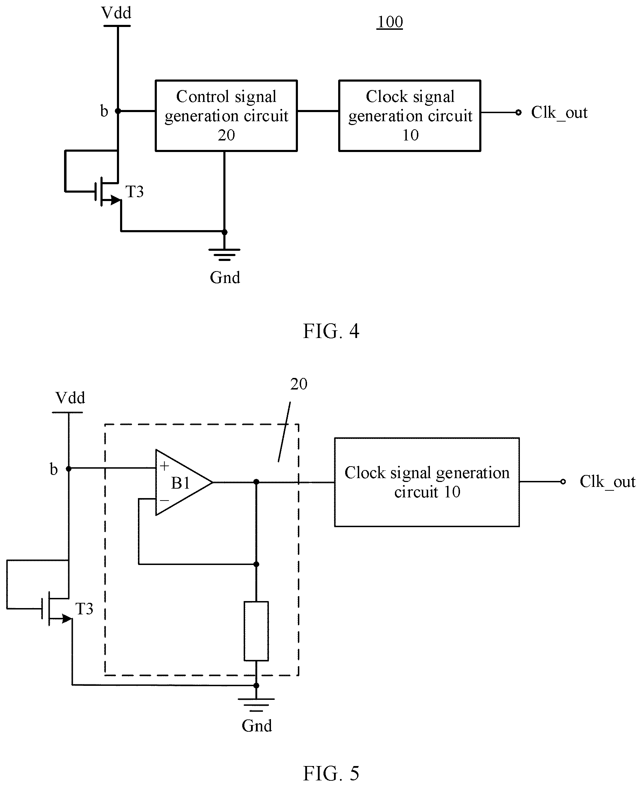

As shown in FIG. 3, a capacitor C1 is connected between a control electrode of a transistor T1 and a common ground Gnd, and a capacitor C2 is connected between a control electrode of a transistor T2 and the common ground Gnd. In this case, a changeover switch may be disposed inside a control signal generation circuit 20 to charge/discharge the capacitor C1 and the capacitor C2. When the control signal generation circuit 20 charges the capacitor C1 and the capacitor C2, a control signal output by the control signal generation circuit 20 is a current signal. The capacitor C1 is used as an example. The control signal generation circuit 20 inputs a current signal to the capacitor C1, the capacitor C1 is charged, and an electric potential at a node n1 gradually rises. When the electric potential at the node n1 rises to a specific value, so that a voltage between the control electrode and a second electrode of the transistor T1 is greater than a turn-on voltage, the transistor T1 is turned on. When an internal current signal generation end of the control signal generation circuit 20 is switched to a low electric potential end (for example, a common ground end), the capacitor C1 is discharged. Under an action of the capacitor C1, the electric potential at the node n1 does not change abruptly. When the capacitor C1 is discharged to a specific value, and a voltage on the transistor T1 is less than the turn-on voltage, the transistor T1 is turned off. When the capacitor C1 is charged, the capacitor C2 is discharged. When the capacitor C2 is charged, the capacitor C1 is discharged. Therefore, the transistor T1 and the transistor T2 are alternately turned on and turned off by controlling alternate charging/discharging of the capacitor C1 and the capacitor C2. In a possible implementation, the clock signal generator 100 further includes a third transistor T3, as shown in FIG. 4. In FIG. 4, the transistor T3 may be an NMOS transistor, a PMOS transistor, or the like. This is not limited herein. A control electrode and a first electrode of the transistor T3 are coupled to a power supply end Vdd. The power supply end Vdd is configured to receive electric energy provided externally. A second electrode of the transistor T3 is coupled to a common ground Gnd. When external electric energy of the clock signal generator 100 is provided to the control electrode and the first electrode of the transistor T3 through the power supply end Vdd, a voltage between the control electrode and the second electrode of the transistor T3 is greater than a turn-on voltage, and the transistor T3 is turned on. In this case, an electric potential at a node b in FIG. 4 is equal to a voltage drop between the first electrode and the second electrode of the transistor T3. In FIG. 4, as long as a voltage difference between electric energy provided by the power supply end Vdd and the common ground Gnd is greater than a conduction voltage of the transistor T3, the transistor can work in on-state, and even if a power signal changes, the electric potential at the node b is not greatly affected. Therefore, a stable voltage signal can be provided for a control signal generation circuit 20 by disposing the transistor T3, so that the control signal generation circuit 20 provides a stable current signal for a clock signal generation circuit 10.

In FIG. 4, the control signal generation circuit 20 may convert a voltage signal between the first electrode and the second electrode of the transistor T3 into a current signal, and alternately provide the current signal to the capacitor C1 and the capacitor C2 shown in FIG. 3.

In this implementation, the control signal generation circuit 20 may be a circuit whose output current and input voltage are in a proportional relationship. In the conventional technology, any circuit whose output current and input voltage can be in a proportional relationship may be used as the control signal generation circuit 20 shown in this application. This is not specifically limited herein. In specific implementation, the control signal generation circuit 20 may have a structure shown in FIG. 5. In the control signal generation circuit shown in FIG. 5, a current output by an output end of an integrated operational amplifier B1 is equal to a sum of a bias voltage of the integrated operational amplifier and an electric potential at a node b divided by a resistance value of a resistor R. The bias voltage of the integrated operational amplifier B1 and the resistance value of the resistor R are set, so that the output current of the integrated operational amplifier B1 and the electric potential at the node b have a proportional relationship.

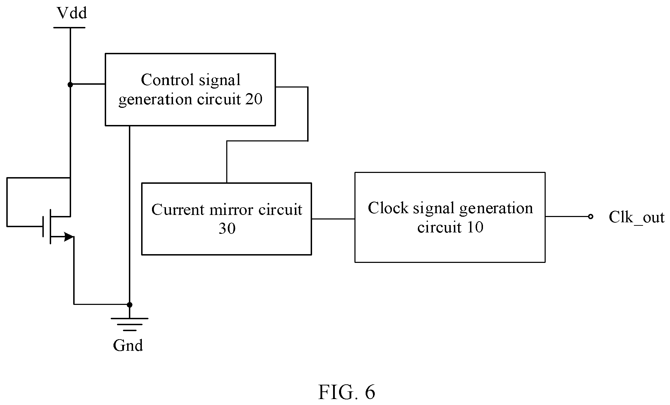

In some optional implementations, the clock signal generator 100 may further include a current mirror circuit 30. FIG. 6 is a schematic diagram of a connection relationship between the current mirror circuit 30 and other circuit elements. An output end of a control signal generation circuit 20 is coupled to an input end of the current mirror circuit 30. An output end of the current mirror circuit 30 is coupled to a control electrode of a transistor T1 and a control electrode of a transistor T2 in a clock signal generation circuit 10. After performing mirror processing on a received current signal, the current mirror circuit 30 provides the current signal to a capacitor C1 and a capacitor C2 in the clock signal generation circuit 10 through the output end. The control signal generation circuit 20 may be a circuit whose output current and input voltage are in a proportional relationship, for example, may have a circuit structure of the control signal generation circuit 20 shown in FIG. 5. The current mirror circuit 30 may be a current mirror circuit for performing mirror processing on a current at a preset ratio, or a circuit for amplifying a current at a preset ratio. For example, a ratio of currents of an input end and an output end of the current mirror circuit is 1:N. Herein, N is an integer greater than or equal to 1. In other words, in this optional implementation, the current mirror circuit 30 performs, at a preset ratio, mirror processing on a current input by the control signal generation circuit 20, and provides a processed current to the clock signal generation circuit 10.

In this optional implementation, a requirement on the control signal generation circuit 20 can be reduced by disposing the current mirror circuit 30. When a relatively large current needs to be input to the clock signal generation circuit 10, the current mirror circuit 30 may be used for implementation, so that stability of the control signal generation circuit 20 can be improved. This further improves stability of a clock signal generated by the clock signal generator 100.

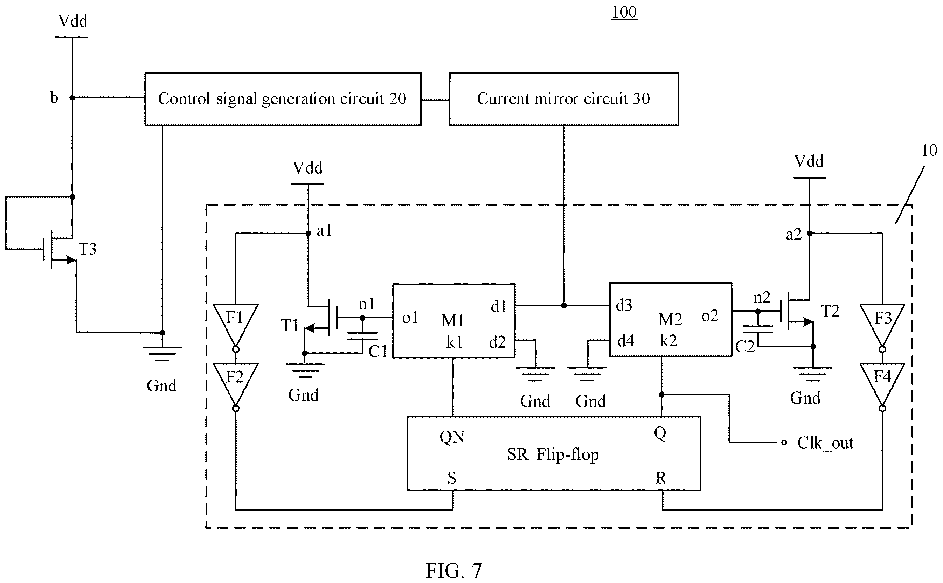

With reference to FIG. 7, the following describes a specific structure of a clock signal generator 100 according to an embodiment of this application.

In FIG. 7, the clock signal generator 100 includes a clock signal generation circuit 10, a control signal generation circuit 20, a current mirror circuit 30, a transistor T3, a power supply end Vdd, and a clock signal output end Clk_out. The clock signal generation circuit 10 includes a transistor T1, a transistor T2, an SR flip-flop, a capacitor C1, and a capacitor C2. For connection relationships between components in the clock signal generation circuit 10, refer to related descriptions in FIG. 2 and FIG. 3. For structures of units and connection relationships in the control signal generation circuit 20 and the current mirror circuit 30, refer to related descriptions in FIG. 4 to FIG. 6. Details are not described herein again.

In the clock signal generator 100 shown in FIG. 7, the clock signal generation circuit 10 further includes a selector M1 and a selector M2. A control end k1 of the selector M1 is coupled to an output end QN of the SR flip-flop. An input end d1 of the selector M1 is coupled to an output end of the current mirror circuit 30. An input end d2 of the selector M1 is coupled to a common ground Gnd. An output end o1 of the selector M1 is coupled to a control electrode of the transistor T1. A control end k2 of the selector M2 is coupled to an output end Q of the SR flip-flop. An input end d3 of the selector M2 is coupled to the output end of the current mirror circuit 30. An input end d4 of the selector M2 is coupled to the common ground Gnd. An output end o2 of the selector M2 is coupled to a control electrode of the transistor T2. The capacitor C1 is coupled between the control electrode of the transistor T1 and the common ground Gnd. The capacitor C2 is coupled between the control electrode of the transistor T2 and a common ground Gnd.

Working principles of the selector M1 and the selector M2 are described by using the selector M1 as an example. When the control end k1 of the selector M1 receives "logic 0" or a low-level signal, the selector M1 gates the input end d1. In this case, an output end of a current mirror circuit 30 is connected to the control electrode of the transistor T1, the capacitor C1 is charged, and an electric potential at a node n1 gradually rises. When the electric potential at the node n1 rises to a specific value, so that a voltage between the control electrode and a second electrode of the transistor T1 is greater than a turn-on voltage, the transistor T1 is turned on. When the control end k1 of the selector M1 receives "logic 1" or a high-level signal, the selector M1 gates the input end d2. In this case, the control electrode of the transistor T1 is connected to the common ground Gnd, and the capacitor C1 is discharged. Under an action of the capacitor C1, the electric potential at the node n1 does not change abruptly. When the capacitor C1 is discharged to a specific value, and a voltage on the transistor T1 is less than the turn-on voltage, the transistor T1 is turned off. The working principle of the selector M2 is the same as that of the selector M1. Details are not described again.

In FIG. 7, the transistor T1 and the transistor T2 are turned on or turned off through charging/discharging of the capacitor C1 and the capacitor C2. The capacitor C1, the capacitor C2, the selector M1, the selector M2, the transistor T1, the transistor T2, and the SR flip-flop work together to periodically generate a clock signal.

Specifically, a level signal at the output end QN of the SR flip-flop is the same as a level signal at an input end S of the SR flip-flop, and a level signal at the output end Q of the SR flip-flop is the same as a level signal at an input end R of the SR flip-flop.

It is assumed that at a current moment, the output end QN of the SR flip-flop outputs "logic 1" or a high-level signal, and the output end Q of the SR flip-flop outputs "logic 0" or a low-level signal. In a first time period, the capacitor C1 is charged, and the electric potential at the node n1 gradually rises. When the electric potential at the node n1 rises to a specific value, the transistor T1 is turned on, so that an electric potential at a node a1 is a low electric potential. The input end S of the SR flip-flop receives the low-level signal or the "logic 0", and in this case, the output end QN of the SR flip-flop is triggered to flip. That is, the output end QN of the SR flip-flop outputs the "logic 0" or the low-level signal. The capacitor C2 is discharged, and an electric potential at a node n2 gradually decreases. When the electric potential at the node n2 decreases to a specific value, the transistor T2 is turned off, so that an electric potential at a node a2 is a high electric potential. The input end R of the SR flip-flop receives the high-level signal, and in this case, the output end Q of the SR flip-flop is triggered to flip. That is, the output end Q of the SR flip-flop outputs the "logic 1" or the high-level signal. Then, a second time period is entered.

In the second time period, the capacitor C1 is discharged, and the electric potential at the node n1 gradually decreases. When the electric potential at the node n1 decreases to a specific value, the transistor T1 is turned off, so that the electric potential at the node a1 is a high electric potential. The input end S of the SR flip-flop receives the high-level signal or the "logic 1", and in this case, the output end QN of the SR flip-flop is triggered to flip. That is, the output end QN of the SR flip-flop outputs the "logic 1" or the high-level signal. The capacitor C2 is charged, and the electric potential at the node n2 gradually rises. When the electric potential at the node n2 rises to a specific value, the transistor T2 is turned on, so that the electric potential at the node a2 is a low electric potential. The input end R of the SR flip-flop receives the low-level signal, and in this case, the output end Q of the SR flip-flop is triggered to flip. That is, the output end Q of the SR flip-flop outputs the "logic 0" or the low-level signal.

In this way, through charging/discharging of the capacitor C1 and the capacitor C2, the output end Q and the output end QN of the SR flip-flop periodically output the high-level signal and the low-level signal. That is, the clock signals are formed at the output end Q and the output end QN separately. A clock frequency of the clock signal is a level signal flipping frequency of the output end Q or a level signal flipping frequency of the output end QN.

It can be learned from FIG. 7 that, in this embodiment, the transistor T1 and the transistor T2 are controlled through charging/discharging of the capacitor C1 and the capacitor C2, so as to trigger level flipping of the output end QN and the output end Q of the RS flip-flop to generate a clock signal.

A difference from the conventional technology shown in FIG. 1 lies in that, turn-on times and turn-off times of the transistor T1 and the transistor T2 in this embodiment are related only to charging/discharging times of the capacitor C1 and the capacitor C2. The clock frequency output by the clock signal generator 100 can be controlled by controlling the charging/discharging times of the capacitor C1 and the capacitor C2. The charging/discharging times of the capacitor C1 and the capacitor C2 are related to materials and capacities of the capacitor C1 and the capacitor C2, and charging/discharging constants of the capacitors. In this way, the turn-on times and turn-off times of the transistor T1 and the transistor T2 are turned off from an output current of the control signal generation circuit 20, so that the clock signal output by the SR flip-flop is turned off from the control signal generation circuit. This avoids a change of a turn-on/off time of a transistor caused by a temperature drift and a change of a static operating point of an integrated operational amplifier in the control signal generation circuit, and improves stability of an output clock signal. In addition, in some application scenarios, when a relatively high clock frequency is required, a capacitor with a small capacity and a short charging/discharging time may be used. When a relatively low clock frequency is required, a capacitor with a large capacity and a long charging/discharging time may be used. Therefore, a maximum frequency of a clock signal to be output by the clock signal generator 100 can be effectively increased, and performance of the clock signal generator is improved.

In some implementations, the input end S of the SR flip-flop is coupled to a first electrode of the transistor T1 through an even quantity of phase inverters; and the input end R of the SR flip-flop is coupled to a first electrode of the transistor T2 through an even quantity of phase inverters. FIG. 7 schematically shows a case in which the input end S of the SR flip-flop is coupled to the first electrode of the transistor T1 through two phase inverters F1 and F2, and the input end R of the SR flip-flop is coupled to the first electrode of the transistor T2 through two phase inverters F3 and F4. The clock signal generator 100 can improve a driving capability of a circuit by disposing the phase inverter F1, the phase inverter F2, the phase inverter F3, and the phase inverter F4. This improves flipping speeds of the level signals at the input end S and the input end R of the SR flip-flop.

In some implementations, parameters of the transistor T1, the transistor T2, and the transistor T3 are associated. Specifically, to provide a stable static operating point for the clock signal generator 100, the transistor T1 and the transistor T2 may have a same physical parameter and a same operating parameter, that is, have same parameters such as a conduction voltage drop, an internal resistance, and a power. There may be a proportional relationship between physical parameters and a proportional relationship between operating parameters of the transistor T1 and the transistor T3. In this way, a current flowing through the node a1 is the same as a current flowing through the node a2, and a current flowing through a node b and a current flowing through the node a1 have a proportional relationship. This reduces a temperature drift of the static operating point of the clock signal generator 100.

In the embodiments shown in FIG. 2 to FIG. 7, a case in which a relationship between a quantity of transistors T1, a quantity of transistors T2, and a quantity of transistors T3 is 1:1:1 is schematically shown. In some scenarios, the quantity of transistors T1, the quantity of transistors T2, and the quantity of transistors T3 may alternatively be in another proportional relationship. For example, there may be two transistors T1, the two transistors T1 are connected in series between the power supply end Vdd and the common ground Gnd, and there may be one transistor T2 and one transistor T3.

An embodiment of this application further provides an on-chip clock system. The on-chip clock system may include any clock signal generator described above and another structure such as a voltage source. The structure such as the voltage source is a conventional and common technology. Details are not described herein.

An embodiment of this application further provides a chip. The chip includes the foregoing on-chip clock system. The on-chip clock system including any clock signal generator described above may provide a stable clock signal for each module inside the chip, so that each module inside the chip works stably based on the clock signal.

Specifically, the chip may be an integrated circuit chip, and includes but is not limited to an artificial intelligence chip, a digital signal processing chip, an image processing chip, and the like. When the chip is configured to provide an image processing function and a data analysis and computing function for an application installed on a terminal device (for example, a mobile phone, a computer, or a wearable intelligent device), the electronic device may be a server device, and the chip may be disposed in the server device. When the chip is applied to the autonomous driving field to provide necessary vehicle-mounted computing, the electronic device may be a vehicle-mounted control device, and the AI chip may alternatively be disposed in the vehicle-mounted control device. Alternatively, the chip may be a 5G chip. In this case, the electronic device may be a base station hardware device that communicates with a terminal, and the AI chip may be disposed in the base station hardware device.

The foregoing describes embodiments of this application with reference to the accompanying drawings. However, this application is not limited to the foregoing specific implementations. The foregoing specific implementations are merely examples, but are not limitative.

## Claims

1. A clock signal generator (100), comprising a first transistor, a second transistor, a flip-flop, a power supply end, and a control signal generation circuit, wherein
a first electrode of the first transistor and a first electrode of the second transistor are directly coupled to the power supply end, and a second electrode of the first transistor and a second electrode of the second transistor are directly coupled to a common ground;
a first input end of the flip-flop is coupled to the first electrode of the first transistor, and a second input end of the flip-flop is coupled to the first electrode of the second transistor;
signal output ends of the control signal generation circuit are respectively coupled to a control electrode of the first transistor and a control electrode of the second transistor;
the control signal generation circuit is configured to periodically provide a control signal to the control electrode of the first transistor and the control electrode of the second transistor, so that the first transistor and the second transistor are alternately turned on and turned off based on the control signal; and
a first output end of the flip-flop is configured to output a clock signal.

2. The clock signal generator (100) according to claim 1, wherein the control signal is a voltage signal.

3. The clock signal generator (100) according to claim 1, wherein the clock signal generator (100) further comprises a first capacitor and a second capacitor, wherein
a first electrode of the first capacitor is coupled to the control electrode of the first transistor, a second electrode of the first capacitor is coupled to the common ground, and the first transistor is periodically turned on or turned off based on charging/discharging of the first capacitor; and
a first electrode of the second capacitor is coupled to the control electrode of the second transistor, a second electrode of the second capacitor is coupled to the common ground, and the second transistor is periodically turned on or turned off based on charging/discharging of the second capacitor.

4. The clock signal generator (100) according to claim 3, wherein the control signal is a current signal, and the control signal generation circuit alternately and periodically provides the current signal to the first electrode of the first capacitor and the first electrode of the second capacitor to charge the first capacitor and the second capacitor.

5. The clock signal generator (100) according to claim 3, wherein the clock signal generator (100) further comprises a third transistor;
a control electrode and a first electrode of the third transistor are coupled to the power supply end, and a second electrode of the third transistor is coupled to the common ground; and
the control signal generation circuit generates a current signal based on a voltage signal between the first electrode and the second electrode of the third transistor.

6. The clock signal generator (100) according to claim 4 or 5, wherein the clock signal generator (100) further comprises a current mirror circuit (30);
the control signal generation circuit provides the current signal to the current mirror circuit (30); and
the current mirror circuit performs mirror processing on a received current based on a preset proportion, and provides a processed current to the first electrode of the first capacitor and the first electrode of the second capacitor.

7. The clock signal generator (100) according to any one of claims 4 to 6, wherein the clock signal generator (100) further comprises a first selector and a second selector;
a control end of the first selector is coupled to the first output end of the flip-flop, a first input end of the first selector is coupled to an output end of the control signal generation circuit, a second input end of the first selector is coupled to the common ground, and an output end of the first selector is coupled to the control electrode of the first transistor;
a control end of the second selector is coupled to a second output end of the flip-flop, a first input end of the second selector is coupled to an output end of the control signal generation circuit, a second input end of the second selector is coupled to the common ground, and an output end of the second selector is coupled to the control electrode of the second transistor;
the first selector periodically gates the first input end and the second input end of the first selector under control of a clock signal that is output by the first output end of the flip-flop, so that the first capacitor is periodically charged and discharged; and
the second selector periodically gates the first input end and the second input end of the second selector under control of the clock signal that is output by the first output end of the flip-flop, so that the second capacitor is periodically charged and discharged.

8. The clock signal generator (100) according to any one of claims 1 to 7, wherein the first input end of the flip-flop is coupled to the first electrode of the second transistor through an even quantity of phase inverters.

9. The clock signal generator (100) according to any one of claims 1 to 8, wherein the second input end of the flip-flop is coupled to the first electrode of the third transistor through an even quantity of phase inverters.

10. The clock signal generator (100) according to claim 5, wherein a quantity of first transistors, a quantity of second transistors, and a quantity of third transistors are in a preset proportion; and
a parameter of the first transistor, a parameter of the second transistor, and a parameter of the third transistor are the same.

11. An on-chip clock system, wherein the on-chip clock system comprises the clock signal generator (100) according to any one of claims 1 to 10.

12. A chip, wherein the chip comprises the on-chip clock system according to claim 11.

## Patentansprüche

1. Taktsignalgenerator (100), umfassend einen ersten Transistor, einen zweiten Transistor, ein Flipflop, ein Stromversorgungsende und eine Steuersignal-Erzeugungsschaltung, wobei
eine erste Elektrode des ersten Transistors und eine erste Elektrode des zweiten Transistors direkt mit dem Stromversorgungsende gekoppelt sind und eine zweite Elektrode des ersten Transistors und eine zweite Elektrode des zweiten Transistors direkt mit einer gemeinsamen Masse gekoppelt sind; ein erstes Eingangsende des Flipflops mit der ersten Elektrode des ersten Transistors gekoppelt ist und ein zweites Eingangsende des Flipflops mit der ersten Elektrode des zweiten Transistors gekoppelt ist;
Signalausgangsenden der Steuersignal-Erzeugungsschaltung jeweils mit einer Steuerelektrode des ersten Transistors und einer Steuerelektrode des zweiten Transistors gekoppelt sind;
die Steuersignal-Erzeugungsschaltung dazu konfiguriert ist, periodisch ein Steuersignal an die Steuerelektrode des ersten Transistors und die Steuerelektrode des zweiten Transistors anzulegen, so dass der erste Transistor und der zweite Transistor basierend auf dem Steuersignal abwechselnd ein- und ausgeschaltet werden; und
ein erstes Ausgangsende des Flipflops dazu konfiguriert ist, ein Taktsignal auszugeben.

2. Taktsignalgenerator (100) nach Anspruch 1, wobei das Steuersignal ein Spannungssignal ist.

3. Taktsignalgenerator (100) nach Anspruch 1, wobei der Taktsignalgenerator (100) ferner einen ersten Kondensator und einen zweiten Kondensator umfasst, wobei
eine erste Elektrode des ersten Kondensators mit der Steuerelektrode des ersten Transistors gekoppelt ist, eine zweite Elektrode des ersten Kondensators mit der gemeinsamen Masse gekoppelt ist und der erste Transistor basierend auf dem Laden/Entladen des ersten Kondensators periodisch ein- oder ausgeschaltet wird; und
eine erste Elektrode des zweiten Kondensators mit der Steuerelektrode des zweiten Transistors gekoppelt ist, eine zweite Elektrode des zweiten Kondensators mit der gemeinsamen Masse gekoppelt ist und der zweite Transistor basierend auf dem Laden/Entladen des zweiten Kondensators periodisch ein- oder ausgeschaltet wird.

4. Taktsignalgenerator (100) nach Anspruch 3, wobei das Steuersignal ein Stromsignal ist und die Steuersignal-Erzeugungsschaltung abwechselnd und periodisch das Stromsignal an die erste Elektrode des ersten Kondensators und die erste Elektrode des zweiten Kondensators anlegt, um den ersten Kondensator und den zweiten Kondensator aufzuladen.

5. Taktsignalgenerator (100) nach Anspruch 3, wobei der Taktsignalgenerator (100) ferner einen dritten Transistor umfasst;
eine Steuerelektrode und eine erste Elektrode des dritten Transistors mit dem Stromversorgungsende gekoppelt sind und eine zweite Elektrode des dritten Transistors mit der gemeinsamen Masse gekoppelt ist; und
die Steuersignal-Erzeugungsschaltung basierend auf einem Spannungssignal zwischen der ersten Elektrode und der zweiten Elektrode des dritten Transistors ein Stromsignal erzeugt.

6. Taktsignalgenerator (100) nach Anspruch 4 oder 5, wobei der Taktsignalgenerator (100) ferner eine Stromspiegelschaltung (30) umfasst;
die Steuersignal-Erzeugungsschaltung das Stromsignal an die Stromspiegelschaltung (30) anlegt; und
die Stromspiegelschaltung basierend auf einem voreingestellten Verhältnis eine Spiegelverarbeitung an einem empfangenen Strom durchführt und der ersten Elektrode des ersten Kondensators und der ersten Elektrode des zweiten Kondensators einen verarbeiteten Strom bereitstellt.

7. Taktsignalgenerator (100) nach einem der Ansprüche 4 bis 6, wobei der Taktsignalgenerator (100) ferner einen ersten Selektor und einen zweiten Selektor umfasst;
ein Steuerende des ersten Selektors mit dem ersten Ausgangsende des Flipflops gekoppelt ist, ein erstes Eingangsende des ersten Selektors mit einem Ausgangsende der Steuersignal-Erzeugungsschaltung gekoppelt ist, ein zweites Eingangsende des ersten Selektors mit der gemeinsamen Masse gekoppelt ist und ein Ausgangsende des ersten Selektors mit der Steuerelektrode des ersten Transistors gekoppelt ist;
ein Steuerende des zweiten Selektors mit einem zweiten Ausgangsende des Flipflops gekoppelt ist, ein erstes Eingangsende des zweiten Selektors mit einem Ausgangsende der Steuersignal-Erzeugungsschaltung gekoppelt ist, ein zweites Eingangsende des zweiten Selektors mit der gemeinsamen Masse gekoppelt ist und ein Ausgangsende des zweiten Selektors mit der Steuerelektrode des zweiten Transistors gekoppelt ist;
der erste Selektor unter Steuerung eines Taktsignals, das vom ersten Ausgangsende des Flipflops ausgegeben wird, periodisch das erste Eingangsende und das zweite Eingangsende des ersten Selektors ansteuert, so dass der erste Kondensator periodisch geladen und entladen wird; und
der zweite Selektor unter Steuerung des Taktsignals, das vom ersten Ausgangsende des Flipflops ausgegeben wird, periodisch das erste Eingangsende und das zweite Eingangsende des zweiten Selektors ansteuert, so dass der zweite Kondensator periodisch geladen und entladen wird.

8. Taktsignalgenerator (100) nach einem der Ansprüche 1 bis 7, wobei das erste Eingangsende des Flipflops mit der ersten Elektrode des zweiten Transistors durch eine gerade Anzahl von Phaseninvertern gekoppelt ist.

9. Taktsignalgenerator (100) nach einem der Ansprüche 1 bis 8, wobei das zweite Eingangsende des Flipflops mit der ersten Elektrode des dritten Transistors durch eine gerade Anzahl von Phaseninvertern gekoppelt ist.

10. Taktsignalgenerator (100) nach Anspruch 5, wobei eine Anzahl von ersten Transistoren, eine Anzahl von zweiten Transistoren und eine Anzahl von dritten Transistoren in einem voreingestellten Verhältnis stehen; und
ein Parameter des ersten Transistors, ein Parameter des zweiten Transistors und ein Parameter des dritten Transistors gleich sind.

11. On-Chip-Taktsystem, wobei das On-Chip-Taktsystem den Taktsignalgenerator (100) nach einem der Ansprüche 1 bis 10 umfasst.

12. Chip, wobei der Chip das On-Chip-Taktsystem nach Anspruch 11 umfasst.

## Revendications

1. Générateur de signaux d'horloge (100), comprenant un premier transistor, un deuxième transistor, une bascule, une extrémité d'alimentation et un circuit de génération de signaux de commande, dans lequel
une première électrode du premier transistor et une première électrode du deuxième transistor sont directement couplées à l'extrémité d'alimentation, et une seconde électrode du premier transistor et une seconde électrode du deuxième transistor sont directement couplées à une masse commune ;
une première extrémité d'entrée de la bascule est couplée à la première électrode du premier transistor, et une seconde extrémité d'entrée de la bascule est couplée à la première électrode du deuxième transistor ;
des extrémités de sortie de signaux du circuit de génération de signaux de commande sont respectivement couplées à une électrode de commande du premier transistor et à une électrode de commande du deuxième transistor ;
le circuit de génération de signaux de commande est configuré pour fournir périodiquement un signal de commande à l'électrode de commande du premier transistor et à l'électrode de commande du deuxième transistor, de sorte que le premier transistor et le deuxième transistor sont alternativement activés et désactivés sur la base des signaux de commande ; et
une première extrémité de sortie de la bascule est configurée pour émettre des signaux d'horloge.

2. Générateur de signaux d'horloge (100) selon la revendication 1, dans lequel le signal de commande est un signal de tension.

3. Générateur de signaux d'horloge (100) selon la revendication 1, dans lequel le générateur de signaux d'horloge (100) comprend également un premier condensateur et un second condensateur, dans lequel
une première électrode du premier condensateur est couplée à l'électrode de commande du premier transistor, une seconde électrode du premier condensateur est couplée à la masse commune, et le premier transistor est périodiquement activé ou désactivé sur la base de la charge/décharge du premier condensateur ; et
une première électrode du second condensateur est couplée à l'électrode de commande du deuxième transistor, une seconde électrode du second condensateur est couplée à la masse commune, et le deuxième transistor est périodiquement activé ou désactivé sur la base de la charge/décharge du second condensateur.

4. Générateur de signaux d'horloge (100) selon la revendication 3, dans lequel le signal de commande est un signal de courant, et le circuit de génération de signaux de commande fournit alternativement et périodiquement le signal de courant à la première électrode du premier condensateur et à la première électrode du second condensateur pour charger le premier condensateur et le second condensateur.

5. Générateur de signaux d'horloge (100) selon la revendication 3, dans lequel le générateur de signaux d'horloge (100) comprend également un troisième transistor ;
une électrode de commande et une première électrode du troisième transistor sont couplées à l'extrémité d'alimentation, et une seconde électrode du troisième transistor est couplée à la masse commune ; et
le circuit de génération de signaux de commande génère un signal de courant sur la base d'un signal de tension entre la première électrode et la seconde électrode du troisième transistor.

6. Générateur de signaux d'horloge (100) selon la revendication 4 ou 5, dans lequel le générateur de signaux d'horloge (100) comprend également un circuit miroir de courant (30) ;
le circuit de génération de signaux de commande fournit le signal de courant au circuit miroir de courant (30) ; et
le circuit miroir de courant réalise un traitement miroir sur un courant reçu sur la base d'une proportion prédéfinie, et fournit un courant traité à la première électrode du premier condensateur et à la première électrode du second condensateur.

7. Générateur de signaux d'horloge (100) selon l'une quelconque des revendications 4 à 6, dans lequel le générateur de signaux d'horloge (100) comprend également un premier sélecteur et un second sélecteur ;
une extrémité de commande du premier sélecteur est couplée à la première extrémité de sortie de la bascule, une première extrémité d'entrée du premier sélecteur est couplée à une extrémité de sortie du circuit de génération de signaux de commande, une seconde extrémité d'entrée du premier sélecteur est couplée à la masse commune, et une extrémité de sortie du premier sélecteur est couplée à l'électrode de commande du premier transistor ;
une extrémité de commande du second sélecteur est couplée à une seconde extrémité de sortie de la bascule, une première extrémité d'entrée du second sélecteur est couplée à une extrémité de sortie du circuit de génération de signaux de commande, une seconde extrémité d'entrée du second sélecteur est couplée à la masse commune, et une extrémité de sortie du second sélecteur est couplée à l'électrode de commande du deuxième transistor ;
le premier sélecteur actionne périodiquement la première extrémité d'entrée et la seconde extrémité d'entrée du premier sélecteur sous la commande d'un signal d'horloge qui est émis par la première extrémité de sortie de la bascule, de sorte que le premier condensateur est périodiquement chargé et déchargé ; et
le second sélecteur actionne périodiquement la première extrémité d'entrée et la seconde extrémité d'entrée du second sélecteur sous la commande du signal d'horloge qui est émis par la première extrémité de sortie de la bascule, de sorte que le second condensateur est périodiquement chargé et déchargé.

8. Générateur de signaux d'horloge (100) selon l'une quelconque des revendications 1 à 7, dans lequel la première extrémité d'entrée de la bascule est couplée à la première électrode du deuxième transistor via une quantité paire d'inverseurs de phase.

9. Générateur de signaux d'horloge (100) selon l'une quelconque des revendications 1 à 8, dans lequel la première extrémité d'entrée de la bascule est couplée à la première électrode du troisième transistor via une quantité paire d'inverseurs de phase.

10. Générateur de signaux d'horloge (100) selon la revendication 5, dans lequel une quantité de premiers transistors, une quantité de deuxièmes transistors et une quantité de troisièmes transistors sont dans une proportion prédéfinie ; et
un paramètre du premier transistor, un paramètre du deuxième transistor et un paramètre du troisième transistor sont les mêmes.

11. Système d'horloge sur puce, dans lequel le système d'horloge sur puce comprend le générateur de signaux d'horloge (100) selon l'une quelconque des revendications 1 à 10.

12. Puce, dans laquelle la puce comprend le système d'horloge sur puce selon la revendication 11.
